# EUROPÄISCHE PATENTANMELDUNG

(11) **EP 0 939 475 A2**
(43) Veröffentlichungstag der Anmeldung: **01.09.1999**
(21) Anmeldenummer: 99103296.2
(22) Anmeldetag: 19.02.1999
(51) Int. Cl.: H02J 7/14, H01M 10/44, G01R 31/36

(54) **Bordnetzschaltung für ein Kraftfahrzeug**

(30) Priorität: 21.02.1998 DE 19807644
(71) Anmelder: Hella KG Hueck & Co., 59552 Lippstadt (DE)
(72) Erfinder: Werner, Helmut, 59329 Wadersloh 2 (DE)

(57) **Zusammenfassung**

Beschrieben wird eine Bordnetzschaltung für ein Kraftfahrzeug mit zwei in Reihe geschalteten Akkumulatoren und einer Ladeausgleichseinrichtung zur Angleichung der Ladezustände der Akkumulatoren.

Gesucht wurde eine einfache Lösung, die es ermöglicht, ohne Meßmittel die einwandfreie Funktion der Ladeausgleichseinrichtung zu überprüfen. Die Lösung besteht in einer optischen Signaleinrichtung, vorzugsweise einer Leuchtdiode, die das Überschreiten einer vorgegebenen Ladeausgleichsstromschwelle anzeigt.

Durch die erfindungsgemäße Schaltung kann zudem ein Defekt des masseseitigen Fahrzeugakkumulators erkannt werden.

## Beschreibung

Die Erfindung betrifft eine Bordnetzschaltung für ein Kraftfahrzeug mit zwei in Reihe geschalteten Akkumulatoren und einer Ladeausgleichseinrichtung zur Angleichung des Ladezustandes der Akkumulatoren.

Die Stromversorgung von 24-Volt-Nutz- und Offroadfahrzeugen basiert gewöhnlich auf zwei hintereinander geschalteten 12-V-Akkumulatoren. Die fahrzeugtypischen Verbraucher sind für die Nennspannung von 24 Volt ausgelegt, andere Verbraucher wie Radio- oder Funkgeräte sind jedoch häufig für eine Nennspannung von 12 Volt ausgelegt. Eine besondere Belastung stellen Anhänger mit 12-Volt-Verbrauchern dar. Da alle Verbraucher (ob 12 Volt oder 24 Volt) mit der Fahrzeugmasse verbunden sind, ist eine symmetrische Verteilung der 12-Volt-Verbraucher auf beide Akkumulatoren nicht möglich. Werden die 12-Volt-Verbraucher nun an den masseseitigen Akkumulatoren angeschlossen, führt dieses dazu, daß die 24-Volt-Verbraucher zusätzlich den an Masse liegenden Akkumulator belasten.

Die Folge ist, daß dieser Akkumulator stärker entladen wird. Beim Aufladen aus dem Generator des Kraftfahrzeuges (der Lichtmaschine) durchfließt der gleiche Strom beide Akkumulatoren. Dies bedeutet, daß nach einer gewissen Zeit bei dem stärker belasteten Akkumulator keine vollständige Aufladung mehr statffindet. Zwischen beiden Akkumulatoren besteht ein ständiges Ungleichgewicht, das dazu führt, daß der eine Akkumulator verhältnismäßig schnell zerstört wird.

Aus der Deutschen Offenlegungsschrift DE 16 55 875 ist bereits eine Ladeausgleichseinrichtung bekannt, bei der zwischen dem Generator und den Akkumulatoren eine Einrichtung geschaltet ist, welche die Teilspannungen der Akkumulatoren miteinander vergleicht und den höher belasteten Akkumulator über einen Nebenwiderstand an den Generator schaltet. Die Regeleinrichtung sorgt also dafür, daß der höher belastete und somit stärker entladene Akkumulator über den Nebenwiderstand entsprechend stärker aufgeladen wird, so daß seiner Zerstörung vorgebeugt wird.

Als einfachstes Ausführungsbeispiel einer derartigen Regeleinrichtung ist dort ein Differentialrelais genannt, welches parallel zu den Akkumulatoren geschaltet ist und das bei Ungleichheit der Akkumulatorspannungen den Stromweg über den Nebenwiderstand einschaltet. Sind beide Wicklungen des Differentialrelais gleich stark belastet, so ist der Relaiskontakt geöffnet, während bei ungleichmäßiger Belastung der Relaiskontakt geschlossen wird und für den vom Generator durch die Akkumulatoren fließenden Strom einen Nebenweg schließt.

Für zeitgemäße Ladeausgleichseinrichtungen liegen selbstverständlich Ausführungen nahe, bei denen auf elektromechanische Bauteile wie Relais zugunsten von verschleißfreien Halbleiterschaltern verzichtet wird.

Die genaue Funktionsweise der Ladeausgleichseinrichtung, speziell wie diese den Ladeausgleichsstrom zur Verfügung stellt, soll im folgenden nicht näher erörtert werden, da dies für die darzustellende Erfindung nicht wesentlich ist.

Die Erfindung beschäftigt sich vielmehr mit dem Problem, wie eine Bordnetzschaltung mit einer Ladeausgleichseinrichtung auf einfache und kostengünstige Weise hinsichtlich ihrer Funktionsfähigkeit prüfbar ausgeführt werden kann.

Zur Überprüfung moderner Kraftfahrzeugelektrik und -elektronik werden oft aufwendige Spezialgeräte vorgesehen. Abgesehen davon, daß solche Spezialgeräte kostenaufwendig und daher nicht überall verfügbar sind, zeigt die Erfahrung, daß Überprüfung und Wartung um so seltener und unregelmäßiger erfolgen, je größer der damit verbundene Aufwand ist.

Es ist daher die Aufgabe der Erfindung, eine Bordnetzschaltung zu schaffen, bei der die Funktionsfähigkeit der Ladeausgleichsschaltung auf einfache Weise, und zwar ohne externe Meßmittel, prüfbar ist. Der hierzu benötigte zusätzliche Schaltungsaufwand soll dabei möglichst gering sein.

Diese Aufgabe wird erfindungsgemäß dadurch gelöst, daß die Ladeausgleichseinrichtung Mittel zur Erfassung des zwischen dem Ausgang aus der Ladeausgleichseinrichtung und dem Verbindungspunkt der Akkumulatoren fließenden Ladeausgleichsstromes aufweist und daß die Ladeausgleichseinrichtung in Abhängigkeit von der Höhe des erfaßten Ladeausgleichsstromes ein optisches Signalmittel aktiviert.

Eine solche Ausführung der Ladeausgleichseinrichtung ist auf äußerst einfache und kostengünstige Weise möglich. Im einfachsten Fall benötigt man nur einen Widerstand im Ladeausgleichsstromkreis, an dem ein zum Ladeausgleichsstrom proportionaler Spannungswert abfällt. Ein Komparator vergleicht diesen Spannungswert mit einer vorgegebenen Spannungsschwelle und steuert bei Überschreitung dieser Spannungsschwelle eine Leuchtdiode an.

Diese äußerst einfache Prüfeinrichtung zeigt bei eingeschalteten 12-V-Lasten entsprechender Größe durch die Leuchtdiode das Fließen eines Ladeausgleichsstromes an. Leuchtet die Leuchtdiode dagegen nicht, so deutet dies entweder auf einen internen Fehler der Ladeausgleichseinrichtung oder auf eine Unterbrechung der Verbindungsleitungen der Ladeausgleichseinrichtung hin.

Besonders vorteilhaft ist zudem, daß eine Fehlfunktion des (für das Fahrzeugbordnetz besonders wichtigen!) masseseitig geschalteten Akkumulators ebenfalls erkannt werden kann.

Hierzu ist es vorteilhaft, wenn die Ladeausgleichsstromstärke, bei der der Komparator die Leuchtdiode einschaltet, etwa dem Gesamtstrom aller 12-V-Blinkleuchten des Kraftfahrzeuges entspricht oder etwas geringer ist. Die Prüfung erfolgt durch Einschalten der Warnblinkanlage und Beobachtung der Leuchtdiode: Bei intaktem masseseitigem Akkumulator blinkt nun die Leuchtdiode im Takt der Warnblinklampen; leuchtet die Leuchtdiode dagegen dauerhaft, so deutet dies auf einen Defekt des Akkumulators hin.

Somit kann bei Wartung des Kraftfahrzeuges ohne zusätzliche externe Meßmittel, allein aus der Beobachtung der Leuchtdiode, eine Vielzahl wichtiger Informationen gewonnen werden.

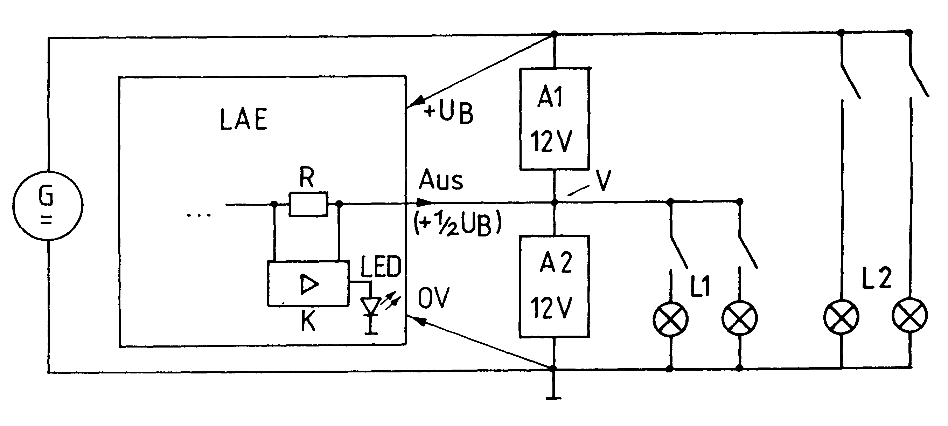

Die einzige Figur zeigt ein schematisch dargestelltes Ausführungsbeispiel der erfindungsgemäßen Bordnetzschaltung.

Diese besteht aus einem Generator (G), welcher mit zwei in Reihe geschalteten Akkumulatoren (A1, A2) mit einer Nennspannung von jeweils 12 Volt verbunden ist und diese lädt, sobald er seine Ladespannung von größer 24 Volt erreicht hat.

An den mit der Fahrzeugmasse verbundenen Akkumulator (A2) sind verschiedene (hier nur symbolisch dargestellte) 12-Volt-Lasten (L1) anschaltbar. Entsprechend ist die Reihenschaltung auch aus den Akkumulatoren A1 und A2 mit 24-Volt-Lasten (L2) elektrisch verbindbar.

Eine solche Schaltungskonfiguration tritt zum Beispiel typischerweise auf, wenn ein Zugfahrzeug mit einem 24-Volt-Bordnetz mit einem Anhänger verbunden ist, der für eine 12-Volt-Versorgung ausgelegt ist.

Da die 24-Volt-Lasten (L2) an beide Akkumulatoren (A1, A2) gleichermaßen angeschaltet sind, die 12-Volt-Lasten (L1) dagegen nur an den masseseitigen Akkumulator (A2), wird der Akkumulator (A2) üblicherweise stärker belastet als der Akkumulator (A1). Die nun auftretende unsymmetrische Entladung der Akkumulatoren wird durch eine Ladeausgleichseinrichtung (LAE) korrigiert. Diese Ladeausgleichseinrichtung (LAE) sorgt für eine symmetrische Aufteilung der Bordnetzspannung (+ U_{B}) auf beide Akkumulatoren (A1, A2) und somit für einen ausgeglichenen Ladezustand.

Um einen minimalen Verkabelungsaufwand sowie möglichst geringe Spannungsabfälle zu erreichen, wird die Ladeausgleichseinrichtung (LAE) vorzugsweise in unmittelbarer Nähe der Akkumulatoren (A1, A2) montiert. Die Ladeausgleichseinrichtung (LAE) regelt den Ausgang (Aus) auf die Hälfte (+ ½ U_{B}) der am + U_{B}-Eingang anliegenden Spannung. Beträgt die Bordnetzspannung zum Beispiel 28 Volt, so wird der Ausgang (Aus) auf 14 Volt ausgeregelt. Wird dabei eine vorgegebene maximale Stromgrenze erreicht, geht die Ladeausgleichseinrichtung so lange in den Konstantstrombetrieb, bis ein ausgeglichener Ladezustand an den Akkumulatoren (A1, A2) erreicht ist.

Die Funktionsweise sei an einem Beispiel aus der Praxis erläutert: Ein 12-Volt-Anhänger wird an einem Fahrzeug mit einem 24-Volt-Bordnetz und einer Ladeausgleichseinrichtung betrieben. Die Ladeausgleichseinrichtung kann an ihrem Ausgang (Aus) beispielsweise einen maximalen Ausgangsstrom von 5 Ampere liefern. Das Standlicht sei eingeschaltet. Bei einem Abbiegevorgang werden zunächst die Richtungsblinkleuchten sowie beim Abbremsen zusätzlich noch die Bremsleuchten betätigt. Die Summe der Ströme im 12-Volt-Kreis erreicht dabei ca. 7 Ampere, wobei die Einschaltstromspitzen jeweils noch weitaus höher liegen. Der Akkumulator (A2) liefert die Stromspitzen (7- bis 10facher Dauerstrom) sowie die Differenz zum maximalen Ladeausgleichsstrom. Da dieser Betriebszustand jedoch nur für relativ kurze Zeit andauert, wird bei der nachfolgenden, weitaus geringeren Belastung des 12-Volt-Kreises der Ladezustand des Akkumulators (A2) durch die Ladeausgleichseinrichtung (LAE) zeitversetzt ausgeglichen.

Die Ladeausgleichseinrichtung (LAE) kann dauernd aktiviert sein oder über die Höhe der Bordnetzspannung (+ U_{B}) als Merkmal für den arbeitenden Generator aktiviert werden, wodurch der Ruhestrom erheblich verringert wird. Die Funktionsfähigkeit der Ladeausgleichseinrichtung (LAE) ist erfindungsgemäß auf überraschend einfache Weise prüfbar. Hierzu weist die Ladeausgleichseinrichtung (LAE) einen Widerstand (R) und einen Komparator (K) sowie ein optisches Signalmittel in Form einer Leuchtdiode (LED) auf.

Der Ausgang (Aus) der Ladeausgleichseinrichtung (LAE) wird auf den halben Wert (+ ½ U_{B}) der Bordnetzspannung (+ U_{B}) geregelt. Fließt über den Ausgang (Aus) ein Ladeausgleichsstrom, fällt am Widerstand (R) eine zum Ladeausgleichsstrom proportionale Spannung ab. Überschreitet dieser Spannungswert (und damit auch der Ladeausgleichsstrom) eine vorgegebene Schwelle, so schaltet der Komparator (K) die Leuchtdiode (LED) als optisches Signalmittel ein.

Anhand der Signale der Leuchtdiode (LED) kann nun ohne weitere Meßmittel die einwandfreie Funktion der Ladeausgleichseinrichtung (LAE) geprüft werden.

Funktioniert die Ladeausgleichseinrichtung (LAE) einwandfrei, so fließt nach dem Einschalten einiger leistungsstarker 12-Volt-Lasten (L1) ein Ladeausgleichsstrom, und die Leuchtdiode (LED) leuchtet.

Fließt dagegen kein Ausgleichsladestrom und leuchtet die Leuchtdiode (LED) somit nicht, so kann auf eine Funktionsstörung der Ladeausgleichseinrichtung geschlossen werden. Mögliche Fehler sind hierbei eine Unterbrechung der Spannungszuführungen (+ U_{B} , 0 Volt) oder in der Verbindung des Ausgangs (Aus) im Verbindungspunkt (V) oder aber ein interner Fehler der Ladeausgleichseinrichtung.

Des weiteren kann auch auf einfache Weise der für das Bordnetz besonders wichtige Akkumulator (A2) überprüft werden. Weist der Akkumulator (A2) zum Beispiel einen internen Schluß auf, so bewirkt dieser ebenfalls einen Ladeausgleichsstrom, durch den die Leuchtdiode (LED) eingeschaltet wird. Ein solcher Fehler kann durch eine Veränderung der Anzahl der eingeschalteten 12-Volt-Lasten (L1) geprüft werden. Vermindert sich nämlich bei einer verringerten Zahl von eingeschalteten 12-Volt-Lasten (L1) der Ladeausgleichsstrom nicht so weit, daß die Leuchtdiode (LED) erlischt, so kann auf einen Defekt des masseseitigen Akkumulators (A2) geschlossen werden.

Da für den Prüfvorgang verschiedene 12-Volt-Lasten ein- bzw. auszuschalten sind, deren Schalteinrichtungen aber nicht am gleichen Anbauort wie die zu beobachtende Leuchtdiode (LED) angeordnet sind, kann der Prüfvorgang, insbesondere wenn er durch eine einzelne Person vorgenommen wird, sehr unkomfortabel sein, da diese ihren Standort mehrmals zwischen der Fahrerkabine und dem Anbringungsort der Ladeausgleichseinrichtung (LAE) wechseln muß.

Dieses wird auf einfache Weise dadurch vermieden, daß die Ladeausgleichsstromschwelle, die zur Einschaltung der Leuchtdiode (LED) erforderlich ist, so festgelegt ist, daß sie durch die Gesamtheit der 12-V-Blinkleuchtenströme des Anhängers gerade überschritten wird.

Hierdurch ist nach Einschalten der Warnblinkanlage (die Funktionsfähigkeit aller Blinkleuchten sei vorausgesetzt) nur noch zu prüfen, ob die Leuchtdiode (LED) im Takt des Warnblinkgebers blinkt.

Ist dies der Fall, kann sowohl die Ladeausgleichseinrichtung (LAE) als auch der masseseitige Akkumulator (A2) als einwandfrei funktionierend angenommen werden.

## Patentansprüche

1. Bordnetzschaltung für ein Kraftfahrzeug mit zwei in Reihe geschalteten Akkumulatoren (A1, A2) und einer Ladeausgleichseinrichtung (LAE) zur Angleichung des Ladezustandes der Akkumulatoren (A1, A2), dadurch gekennzeichnet, daß die Ladeausgleichseinrichtung Mittel (R, K) zur Erfassung des zwischen dem Ausgang (Aus) der Ladeausgleichseinrichtung (LAE) und dem Verbindungspunkt (V) der Akkumulatoren (A1, A2) fließenden Ladeausgleichsstromes aufweist und daß die Ladeausgleichseinrichtung (LAE) in Abhängigkeit von der Höhe des erfaßten Ladeausgleichsstromes ein optisches Signalmittel (LED) aktiviert.

2. Bordnetzschaltung nach Anspruch 1, dadurch gekennzeichnet, daß die Ladeausgleichseinrichtung zur Erfassung des Ladeausgleichsstromes einen in den Ladeausgleichsstromkreis geschalteten Widerstand (R) aufweist.

3. Bordnetzschaltung nach Anspruch 2, dadurch gekennzeichnet, daß die Ladeausgleichseinrichtung (LAE) einen Komparator (K) aufweist, der den am Widerstand (R) abfallenden Spannungswert mit einem vorgegebenen Spannungswert vergleicht.

4. Bordnetzschaltung nach Anspruch 1, dadurch gekennzeichnet, daß das optische Signalmittel eine Leuchtdiode ist.

5. Bordnetzschaltung nach Anspruch 1, dadurch gekennzeichnet, daß die Stromschwelle zur Aktivierung des optischen Signalmittels (LED) kleiner ist als die Gesamtstromstärke aller am Fahrzeug vorhandener 12-V-Verbraucher oder am Anhänger vorhandenen 12-V-Blinkleuchten.
